(19) Europäisches Patentamt
European Patent Office
Office européen des brevets

(11) **EP 4 468 598 A1**

(12) **EUROPEAN PATENT APPLICATION**
published in accordance with Art. 153(4) EPC

(43) Date of publication:
**27.11.2024 Bulletin 2024/48**

(51) International Patent Classification (IPC):
***H03F 1/42*** *(2006.01)*

(21) Application number: 23742917.0

(22) Date of filing: **18.01.2023**

(52) Cooperative Patent Classification (CPC):
**H03F 1/56; H03F 1/02; H03F 1/0288; H03F 1/07;
H03F 1/42; H03F 1/565; H03F 3/189; H03F 3/195;
H03F 3/20; H03F 3/211; H03F 3/245**

(86) International application number:
**PCT/CN2023/072799**

(87) International publication number:
**WO 2023/138602 (27.07.2023 Gazette 2023/30)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.01.2022  CN 202210051876**

(71) Applicant: **Vanchip (Tianjin) Technology Co. Ltd
Tianjin 300457 (CN)**

(72) Inventors:
• **CHEN, Gang
Tianjin 300457 (CN)**
• **BAI, Yunfang
Tianjin 300457 (CN)**

(74) Representative: **Wang, Bo
Panovision IP
Ebersberger Straße 3
85570 Markt Schwaben (DE)**

(54) **HIGH-BANDWIDTH LOAD-MODULATION POWER AMPLIFIER AND CORRESPONDING RADIO FREQUENCY FRONT-END MODULE**

(57)    Disclosed in the present invention are a high-bandwidth load modulation power amplifier, comprising a main-path power amplifier, an auxiliary-path power amplifier, a quadrature coupler, a main-path radio frequency signal matching network, an auxiliary-path radio frequency signal matching network and an output combined-path radio frequency signal matching network. When an input of a radio frequency signal is received, the quadrature coupler divides the input radio frequency signal into two paths of radio frequency signals, which have a 90-degree phase difference therebetween, wherein the radio frequency signal, which has a +45-degree phase, enters the main-path power amplifier, and the radio frequency signal, which has the -45-degree phase, enters the auxiliary-path power amplifier; and the output combined-path radio frequency signal matching network synthesizes a main-path signal and an auxiliary-path signal and then outputs a radio frequency signal. Further provided in the present invention are a radio frequency front-end module comprising the load modulation power amplifier, and a corresponding electronic device. The load modulation power amplifier provided in the present invention has the beneficial effects of a high bandwidth, a high efficiency, a low loss, etc.

FIG. 4

## Description

## BACKGROUND

**Technical Field**

The present invention relates to a high-bandwidth load modulation power amplifier, further relates to a radio frequency front-end module and a corresponding electronic device that include the load modulation power amplifier, and relates to the field of radio frequency integrated circuit technologies.

**Related Art**

A load modulation power amplifier is also referred to as a Doherty power amplifier. A typical Doherty power amplifier includes two amplifiers and an impedance inverting network. One of the amplifiers is referred to as a carrier amplifier (carrier amplifier, also referred to as a main power amplifier) and the other one of the amplifiers is referred to as a peaking amplifier (peaking amplifier, also referred to as an auxiliary power amplifier). An important feature of the Doherty power amplifier is combination of asymmetric output powers of the two amplifiers, to achieve load modulation (load modulation). Specifically, in a case of a small signal (low power), only the carrier amplifier operates at a low power level. In a case of a large signal (high power), the peaking amplifier operates at a higher power level, and the carrier amplifier operates in a peak efficiency mode in the range.

In addition, to meet increasing data throughput a wireless communication system, a high spectral efficiency modulation signal with a high peak-to-average power ratio (PAPR) is needed. Therefore, an efficiency value of a power amplifier at power back-off (Power Back-off) is crucial to reduce power consumption of the wireless communication system. A feature of the load modulation power amplifier is that the load modulation power amplifier has a high efficiency value at power back-off. However, due to an insufficient bandwidth range caused by a circuit structure of the load modulation power amplifier, the load modulation power amplifier power at high efficiency at power back-off can only operate normally in a narrow bandwidth range. For a frequency band with a wide range in the 5th generation (5G) mobile communication technology, for example, a frequency range of an n77 frequency band is 3.3 GHz to 4.2 GHz, and a bandwidth of the frequency band is 900 MHz. In conventional technologies, the load modulation power amplifier cannot meet a technical requirement of the bandwidth range. The following describes the foregoing descriptions in detail.

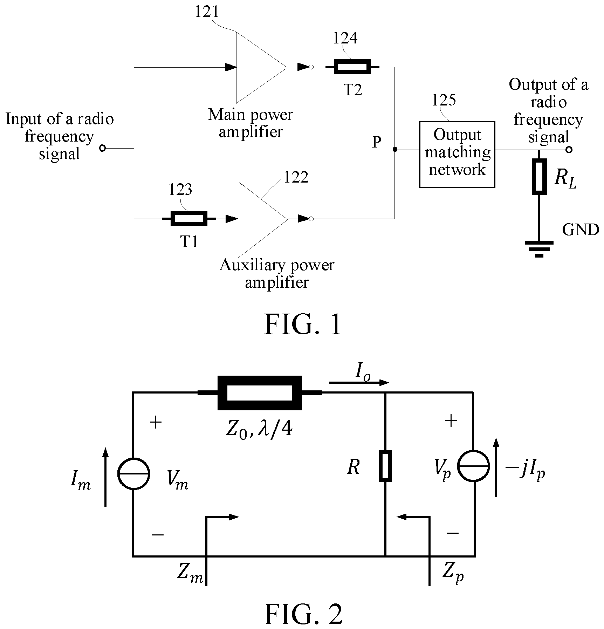

As shown in FIG. 1, in a typical example of the load modulation power amplifier in the conventional technologies, a main power amplifier 121, an auxiliary power amplifier 122, a quarter-wave input transmission line 123, a quarter-wave output transmission line 124, and an output matching network 125 are included. In an ideal case, when radio frequency signals are inputted into a radio frequency signal input end, a part of the radio frequency signals is inputted to the main power amplifier 121, then amplified by the main power amplifier, and then transmitted to the output matching network 125 through the quarter-wave output transmission line 124. Another part of the radio frequency signals is inputted to the quarter-wave input transmission line 123, then transmitted to the auxiliary power amplifier 122, then amplified by the auxiliary power amplifier 122, and then outputted to the output matching network 125. The output matching network 125 combines two channels of the signals to output a radio frequency signal. The main power amplifier is in a Class AB bias state and is in an open state in a case of low power. The auxiliary power amplifier is in a Class C bias state and the auxiliary power amplifier is in an off state in a case of low power. When an input signal is large enough, the auxiliary power amplifier is opened to be in a state of amplifying power.

In the foregoing example of the load modulation power amplifier, the quarter-wave output transmission line 124 and the output matching network 125 are limiting points of a circuit bandwidth. In a case of low power, the quarter-wave output transmission line 124 needs to present a high load line impedance to the main power amplifier. In a case of high power, the quarter-wave output transmission line 124 needs to present a low load line impedance to the main power amplifier. Therefore, switching of an impedance transformation ratio of the quarter-wave output transmission line 124 in a case of different power results in bandwidth limitation.

## SUMMARY

A technical problem to be resolved in the present invention is to provide a high-bandwidth load modulation power amplifier.

Another technical problem to be resolved in the present invention is to provide a radio frequency front-end module and an electronic device that include the foregoing load modulation power amplifier.

To achieve the foregoing objectives, the following technical solutions are used in the present invention.

According to a first aspect of embodiments of the present invention, a high-bandwidth load modulation power amplifier is provided, including a main power amplifier, an auxiliary power amplifier, an orthogonal coupler, a main radio frequency signal matching network, an auxiliary radio frequency signal matching network, and an output combination radio frequency signal matching network.

An input end of the orthogonal coupler is connected to a radio frequency signal input end. An output end with a phase of +45 degrees of the orthogonal coupler is connected to an input end of the main power amplifier. An output end of the main power amplifier is connected to the main radio frequency signal matching network. An output end with a phase of -45 degrees of the orthogonal coupler is connected to an input end of the auxiliary power amplifier. An output end of the auxiliary power amplifier is connected to the auxiliary radio frequency signal matching network.

The other end of the auxiliary radio frequency signal matching network and the other end of the main radio frequency signal matching network are connected in parallel, and then are connected to the output combination radio frequency signal matching network. The other end of the output combination radio frequency signal matching network is connected to a radio frequency signal output end.

Preferably, the main radio frequency signal matching network, the auxiliary radio frequency signal matching network, and the output combination radio frequency signal matching network each include a lumped element.

Preferably, the main radio frequency signal matching network includes a first inductor, a second inductor, a first capacitor, and a second capacitor. One end of the first inductor is connected to the output end of the main power amplifier. The other end of the first inductor is connected to the second inductor and the first capacitor. The other end of the first capacitor is connected to a ground end. The other end of the second inductor is connected to the second capacitor and a fifth inductor of the output combination radio frequency signal matching network. The other end of the second capacitor is connected to a ground end.

Preferably, the auxiliary radio frequency signal matching network includes a third inductor, a fourth inductor, a third capacitor, and a fourth capacitor. One end of the third capacitor is connected to the output end of the auxiliary power amplifier. The other end of the third capacitor is connected to the third inductor and the fourth inductor. The other end of the third inductor is connected to a ground end. The other end of the fourth inductor is connected to the fourth capacitor and a fifth inductor of the output combination radio frequency signal matching network. The other end of the fourth capacitor is connected to a ground end.

Preferably, the output combination radio frequency signal matching network includes the fifth inductor and a fifth capacitor. One end of the fifth inductor is connected to the fifth capacitor and the radio frequency signal output end. The other end of the fifth capacitor is connected to a ground end.

Preferably, the second capacitor in the main radio frequency signal matching network and the fourth capacitor in the auxiliary radio frequency signal matching network are combined into one capacitor.

Preferably, the second capacitor in the main radio frequency signal matching network and the fourth inductor in the auxiliary radio frequency signal matching network are simplified and canceled when resonant frequencies and operating frequencies of the second capacitor and the fourth inductor are equal.

Preferably, the auxiliary radio frequency signal matching network includes a third inductor, a fourth inductor, a third capacitor, and a fourth capacitor. One end of the third inductor is connected to the output end of the auxiliary power amplifier. The other end of the third inductor is connected to the third capacitor and the fourth capacitor. The other end of the third capacitor is connected to a ground end. The other end of the fourth capacitor is connected to the fourth inductor and a fifth capacitor of the output combination radio frequency signal matching network. The other end of the fourth inductor is connected to a ground end.

The output combination radio frequency signal matching network includes a fifth inductor and the fifth capacitor. The other end of the fifth capacitor is connected to the fifth inductor and the radio frequency signal output end. The other end of the fifth inductor is connected to a ground end.

According to a second aspect of embodiments of the present invention, a radio frequency front-end module is provided, including the foregoing load modulation power amplifier.

According to a third aspect of embodiments of the present invention, an electronic device is provided, including the foregoing load modulation power amplifier.

Compared with conventional technologies, an operating bandwidth of the load modulation power amplifier provided in the present invention is a plurality of times greater than that in the conventional technologies, and operating efficiency at power back-off of the load modulation power amplifier is effectively improved. In addition, an insertion loss of the load modulation power amplifier provided in the present invention is obviously less than that of a similar product in the conventional technologies. Therefore, the load modulation power amplifier provided in the present invention better meets feature requirements provided in the 5th generation (5G) mobile communication technology, such as a high-bandwidth, high efficiency, and a low loss.

## BRIEF DESCRIPTION OF THE DRAWINGS

FIG. 1 is an example diagram of a load modulation power amplifier in conventional technologies;

FIG. 2 is a schematic diagram of performing load line transformation on the load modulation power amplifier shown in FIG. 1;

FIG. 3 is a circuit schematic diagram of replacing a load line structure of the load modulation power amplifier shown in FIG. 1 with a lumped element;

FIG. 4 is a schematic diagram of an embodiment of a load modulation power amplifier according to the present invention;

FIG. 5 is a schematic diagram of a deformation example of the load modulation power amplifier shown in FIG. 4;

FIG. 6 is a schematic diagram of an equivalent structure of the deformation example shown in FIG. 5 when operating in a case of low power;

FIG. 7 is a schematic diagram of another deformation example of the load modulation power amplifier shown in FIG. 4;

FIG. 8 is a schematic diagram of still another deformation example of the load modulation power amplifier shown in FIG. 4;

FIG. 9 is a schematic diagram of an emulation test result of an insertion loss of a load modulation power amplifier according to the present invention;

FIG. 10 is a schematic diagram of an emulation test result of an efficiency value of a load modulation power amplifier according to the present invention; and

FIG. 11 is an example diagram of an electronic device using a load modulation power amplifier according to the present invention.

## DETAILED DESCRIPTION

Technical solutions of the present invention are further described in detail below with reference to accompanying drawings and specific embodiments.

To describe a technical principle of the present invention more clearly, a principle of load line transformation is first analyzed by the inventor based on the Kirchhoffs law. FIG. 2 is a schematic diagram of performing load line transformation on the load modulation power amplifier shown in FIG. 1. As shown in FIG. 2, a relational expression between a main operating voltage and operating current and an auxiliary operating voltage and operating current can be derived as follows:

$$\begin{bmatrix} V_m \\ I_m \end{bmatrix} = \begin{bmatrix} 0 & jZ_0 \\ j(1/Z_0) & 0 \end{bmatrix} \begin{bmatrix} V_p \\ I_o \end{bmatrix} \tag{1}$$

$$I_o = \frac{V_p}{R} + jI_p \tag{2}$$

$V_m$ is the main operating voltage, $I_m$ is the main operating current, $V_p$ is the auxiliary operating voltage, $I_p$ is the auxiliary operating current, $I_o$ is an output current that passes through a transmission line in a main circuit, $Z_0$ is a characteristic impedance value of a transmission line in a main circuit, and R is a load impedance.

Through calculation, a main load line impedance $Z_m$ and an auxiliary load line impedance $Z_p$ may be obtained:

$$Z_m = \frac{Z_0^2}{R} - Z_0 \frac{I_p}{I_m} \tag{3}$$

$$Z_p = Z_0 \frac{I_m}{I_p} \tag{4}$$

It can be learned from formula (3), when an inputted radio frequency signal is a small signal (low power), an auxiliary power amplifier is not opened. That is, $I_p$ is equal to 0. Assuming that $R = (1/2)Z_0$, a load line impedance $Z_m$ of a main power amplifier is: $Z_0^2/R = 2Z_0$ , and a load line impedance of the auxiliary power amplifier is infinite. When the inputted radio frequency signal is gradually larger, the main power amplifier is enabled to be in a saturation state. In other words, when $I_m$ is constant, the auxiliary power amplifier is opened, and when the operating current $I_p$ is larger, the load line impedance $Z_m$ of the main power amplifier is gradually decreased, and the load line impedance $Z_p$ of the auxiliary power amplifier is also gradually decreased. Assuming that $I_p = I_m$ and $R = (1/2)Z_0$, the load line impedance of the main power amplifier is: $Z_m = Z_0^2/R - Z_0 = Z_0$, and the load line impedance of the auxiliary power amplifier is: $Z_p = Z_0$. It can be learned that when the inputted signal changes from small to large, the load line impedance of the main power amplifier is also decreased from $2Z_0$ to $Z_0$, thereby achieving an effect of load line impedance modulation and improving efficiency at power back-off. The load line impedance of the auxiliary power amplifier also changes from infinity to $Z_0$, thereby further increasing output power of the load modulation power amplifier.

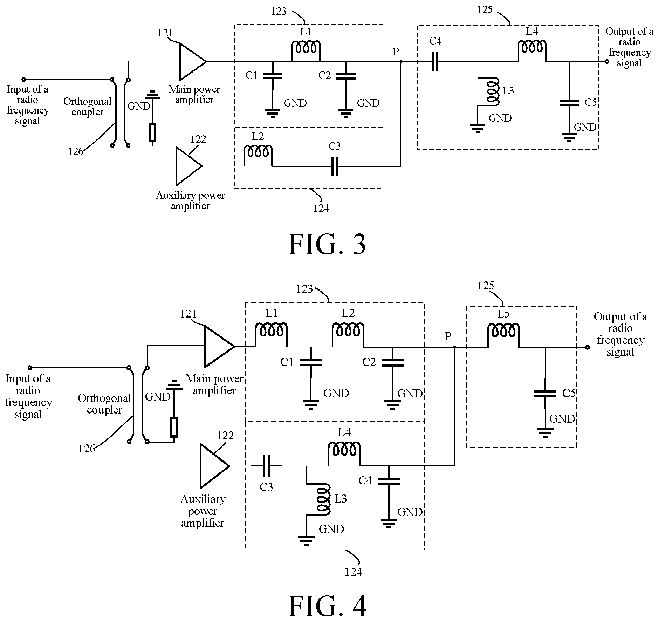

When the load modulation power amplifier shown in FIG. 1 receives input of the radio frequency signal, an orthogonal coupler 126 (refer to FIG. 3) divides the inputted radio frequency signal into two channels of radio frequency signals with a phase difference of 90 degrees. A radio frequency signal with a phase of +45 degrees enters a main power amplifier 121, and a radio frequency signal with a phase of -45 degrees enters an auxiliary power amplifier 122. When the inputted radio frequency signal is in a low-power state, the auxiliary power amplifier 122 is not opened, and the main power amplifier presents a high load line impedance. When the inputted radio frequency signal is in a high-power state, the auxiliary power amplifier 122 is opened, and a low load line impedance is presented in both a main circuit and an auxiliary circuit.

As shown in FIG. 3, a load line structure of the load modulation power amplifier shown in FIG. 1 is replaced with a lumped element, specifically including a main radio frequency signal matching network 123 (a PI network), an auxiliary radio frequency signal matching network 124 (an LC resonant network), and an output combination radio frequency signal matching network 125. The main radio frequency signal matching network 123 includes a parallel capacitor C1, a series inductor L1, and a parallel capacitor C2. The auxiliary radio frequency signal matching network 124 includes a series inductor L2 and a series capacitor C3. The output combination radio frequency signal matching network 125 includes a series capacitor C4, a parallel inductor L3, a series inductor L4, and a parallel capacitor C5.

The output combination radio frequency signal matching network 125 transforms an antenna impedance $R_L$ to an impedance at point P. $Z_P$ is generally designed as $R_{opt}/2$. The main radio frequency signal matching network 123 is configured to replace a quarter-wave output transmission line 124 in FIG. 1, and a characteristic impedance of the main radio frequency signal matching network 123 is $R_{opt}$. When the inputted radio frequency signal is in a case of low power, the impedance at point P $R_{opt}/2$ is transformed to $2R_{opt}$. When the inputted radio frequency signal is in a case of high power, the auxiliary power amplifier provides an operating current at point P, and the impedance at point P is transformed to $R_{opt}$, so that the load line impedance of the main power amplifier is decreased from $2R_{opt}$ to $R_{opt}$.

Accordingly, a $Q_m$ value of the main radio frequency signal matching network 123 is:

$$Q_m = \sqrt{\frac{2R_{opt}}{R_{opt}/2} - 1} = \sqrt{3} \qquad (5)$$

Assuming that $R_L$ is 50 Ohm and $R_{opt}$ is 6.25 Ohm, a $Q_L$ value of the output combination radio frequency signal matching network 125 can be calculated as follows:

$$Q_L = \sqrt{\sqrt{\frac{R_L}{R_{opt}/2}} - 1} = \sqrt{3} \qquad (6)$$

The auxiliary radio frequency signal matching network 124 is the LC resonant network with a large Q value, and influence on load modulation can be ignored.

According to a network bandwidth formula, a bandwidth (Band Width, BW for short) value of the load modulation power amplifier shown in FIG. 1 can be calculated as follows:

$$BW = \frac{2\pi f_c}{Q_m \cdot Q_L} = \frac{2\pi f_c}{3} \qquad (7)$$

A larger BW value indicates a wider bandwidth of the load modulation power amplifier.

Assuming that in a matching network, a $Q_u$ value of a component is 10, an insertion loss of the load modulation power amplifier shown in FIG. 1 can be calculated according to an insertion loss formula:

$$IL = 10 \cdot log_{10}\left(\frac{1}{1 + \frac{Q_m}{Q_u}} \cdot \frac{1}{1 + \frac{Q_L}{Q_u}}\right) = -1.39\, dBc \qquad (8)$$

Based on the foregoing theoretical analysis, the present invention provides an improved load modulation power amplifier. As shown in FIG. 4, to achieve a high-bandwidth, the load modulation power amplifier shown in this embodiment includes an orthogonal coupler 126, a main power amplifier 121, an auxiliary power amplifier 122, a main radio frequency signal matching network 123, an auxiliary radio frequency signal matching network 124, and an output combination radio frequency signal matching network 125. An input end of the orthogonal coupler 126 is connected to a radio frequency signal input end. An output end with a phase of +45 degrees of the orthogonal coupler 126 is connected to an input end of the main power amplifier 121. An output end of the main power amplifier 121 is connected to the main radio frequency signal matching network 123. An output end with a phase of -45 degrees of the orthogonal coupler 126 is connected to an input end of the auxiliary power amplifier 122. An output end of the auxiliary power amplifier 122 is connected to the auxiliary radio frequency signal matching network 124. The other end of the auxiliary radio frequency signal matching network 124 and the other end of the main radio frequency signal matching network 123 are connected in parallel, and then are connected to the output combination radio frequency signal matching network 125. The other end of the output combination radio frequency signal matching network 125 is connected to a radio frequency signal output end.

In the embodiment shown in FIG. 4, the main radio frequency signal matching network 123, the auxiliary radio frequency signal matching network 124, and the output combination radio frequency signal matching network 125 each include a lumped element. Specific descriptions are as follows.

The main radio frequency signal matching network 123 is an LCLC two-stage network structure, and includes a first inductor L1, a second inductor L2, a first capacitor C1, and a second capacitor C2. One end of the first inductor L1 is connected to the output end of the main power amplifier 121. The other end of the first inductor L1 is connected to the second inductor L2 and the first capacitor C 1. The other end of the first capacitor C1 is connected to a ground end GND. The other end of the second inductor L2 is connected to the second capacitor C2 and a fifth inductor L5 of the output combination radio frequency signal matching network 125. The other end of the second capacitor C2 is connected to a ground end GND.

The auxiliary radio frequency signal matching network 124 is a CLLC two-stage network structure, and includes a third inductor L3, a fourth inductor L4, a third capacitor C3, and a fourth capacitor C4. One end of the third capacitor C3 is connected to the output end of the auxiliary power amplifier 122. The other end of the third capacitor C3 is connected to the third inductor L3 and the fourth inductor L4. The other end of the third inductor L3 is connected to a ground end GND. The other end of the fourth inductor L4 is connected to the fourth capacitor C4 and a fifth inductor L5 of the output combination radio frequency signal matching network 125. The other end of the fourth capacitor C4 is connected to a ground end GND.

The output combination radio frequency signal matching network 125 is an LC single-stage network structure, and includes a fifth inductor L5 and a fifth capacitor C5. The other end of the fifth inductor L5 is connected to the fifth capacitor C5 and the radio frequency signal output end, and the other end of the fifth capacitor C5 is connected to a ground end GND.

In the embodiment of the load modulation power amplifier shown in FIG. 4, when receiving an inputted radio frequency signal, the orthogonal coupler 126 divides the inputted radio frequency signal into two channels of radio frequency signals with a phase difference of 90 degrees. A radio frequency signal with a phase of +45 degrees enters the main power amplifier 121, and a radio frequency signal with a phase of -45 degrees enter the auxiliary power amplifier 122. When the inputted radio frequency signal is in a case of low power, the auxiliary power amplifier 122 is in an off state, the main power amplifier 121 is in an operating state, and a high load line impedance is presented in the main circuit. When the inputted radio frequency signal is in a case of high power, the auxiliary power amplifier 122 is opened and is in an operating state, and a low load line impedance is presented in both a main circuit and an auxiliary circuit. The output combination radio frequency signal matching network 125 combines the main signal and the auxiliary signal to output a radio frequency signal.

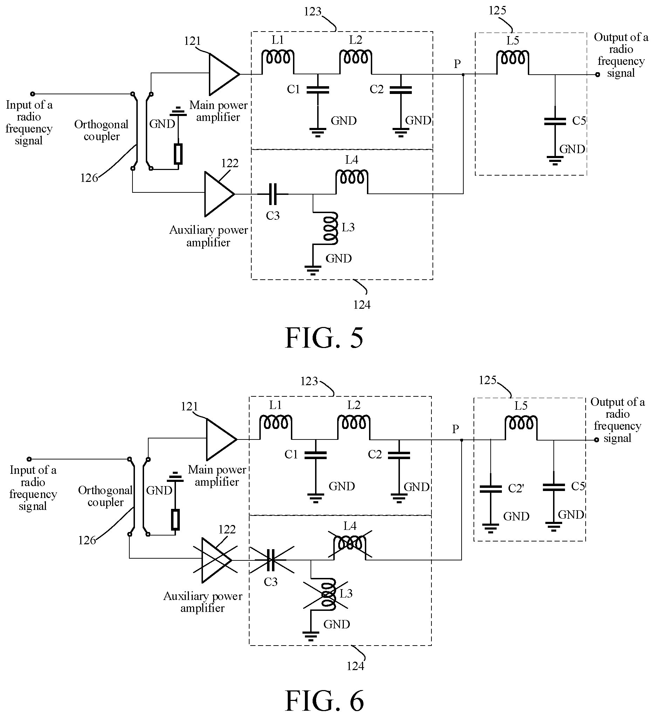

Based on the embodiment of the load modulation power amplifier shown in FIG. 4, the present invention further provides a plurality of deformation examples of the embodiment. For example, in a deformation example shown in FIG. 5, the two capacitors C2 and C4 connected at point P in FIG. 4 are combined into one capacitor, that is, a capacitor C2 in FIG. 5.

FIG. 6 is a schematic diagram of a simplified structure of the deformation example shown in FIG. 5 when working in a case of a small signal (low power). When an inputted radio frequency signal is a small signal, an auxiliary power amplifier is in an off state without an output current. An auxiliary component involved in matching may be equivalent to C2', and a PI network includes the C2' and an output combination radio frequency signal matching network 125. An antenna impedance $R_L$ is transformed to $4R_{opt}$ at point P. $R_{opt}$ is a characteristic impedance of a main radio frequency signal matching network. A function of the main radio frequency signal matching network 123 is to transform a load line impedance $Z_m$ in a main circuit to a low impedance. When a selected optimal impedance transformation ratio is 2, a load line impedance $Z_m$ of a main power amplifier 121 is $2R_{opt}$. When the inputted radio frequency signal is a large signal (high power), as shown in FIG. 5, an operating current is provided at point P after the auxiliary power amplifier is opened, and the impedance at point P is transformed to $2R_{opt}$, so that the load line impedance $Z_m$ of the main power amplifier is decreased from $2R_{opt}$ to $R_{opt}$. At this time, the load line impedance of the auxiliary power amplifier $Z_P$ is $R_{opt}$.

In summary, when the inputted radio frequency signal changes from small to large, the load line impedance $Z_m$ of the main power amplifier is also decreased from $2R_{opt}$ to $R_{opt}$, thereby achieving an effect of load line impedance modulation and improving efficiency at power back-off. In addition, the load line impedance $Z_P$ of the auxiliary power amplifier also changes from infinity to $R_{opt}$, thereby increasing output power of a load modulation power amplifier.

Accordingly, a $Q_m$ value of the main radio frequency signal matching network 123 is:

$$Q_m = \sqrt{\frac{2R_{opt}}{R_{opt}} - 1} = 1 \qquad (9)$$

Assuming that $R_L$ is 50 Ohm and $R_{opt}$ is 6.25 Ohm, a $Q_L$ value of the output combination radio frequency signal matching network 125 can be calculated as follows:

$$Q_L = \sqrt{\frac{R_L}{4R_{opt}} - 1} = 1 \qquad (10)$$

According to a network bandwidth formula, a bandwidth (BW) of the load modulation power amplifier in the embodiment can be calculated as follows:

$$\text{BW} = \frac{2\pi f_c}{Q_m \cdot Q_L} = 2\pi f_c \qquad (11)$$

$f_c$ is an operating frequency.

It can be learned that the bandwidth of the load modulation power amplifier provided in the embodiment of the present invention is three times that of the conventional load modulation power amplifier shown in FIG. 1.

Assuming that in a matching network, a $Q_u$ value of a component is 10, an insertion loss of the load modulation power amplifier shown in FIG. 4 can be calculated according to an insertion loss formula:

$$\text{IL} = 10 \cdot \log_{10}\left(\frac{1}{1 + \frac{Q_m}{Q_u}} \cdot \frac{1}{1 + \frac{Q_L}{Q_u}}\right) = -0.83 \, dBc \qquad (12)$$

Therefore, the insertion loss of the load modulation power amplifier provided in the embodiment of the present invention is significantly reduced, compared with the insertion loss -1.39 *dBc* of the load modulation power amplifier in the conventional technologies shown in FIG. 1.

It should be noted that the foregoing calculation results for the bandwidth and the insertion loss of the load modulation power amplifier provided in the present invention are calculation results obtained based on that the selected optimal impedance transformation ratio is 2 when the main radio frequency signal matching network 123 transforms the load line impedance $Z_m$ of the main circuit. In another embodiment of the present invention, the selected impedance transformation ratio may be another value, such as 1.8 or 2.2. It can be learned from calculation of the foregoing formulas 11 and 12 that the bandwidth and the insertion loss value of the load modulation power amplifier may be improved within a range. For example, the bandwidth may range from 1 to 3 times (compared with the conventional technologies).

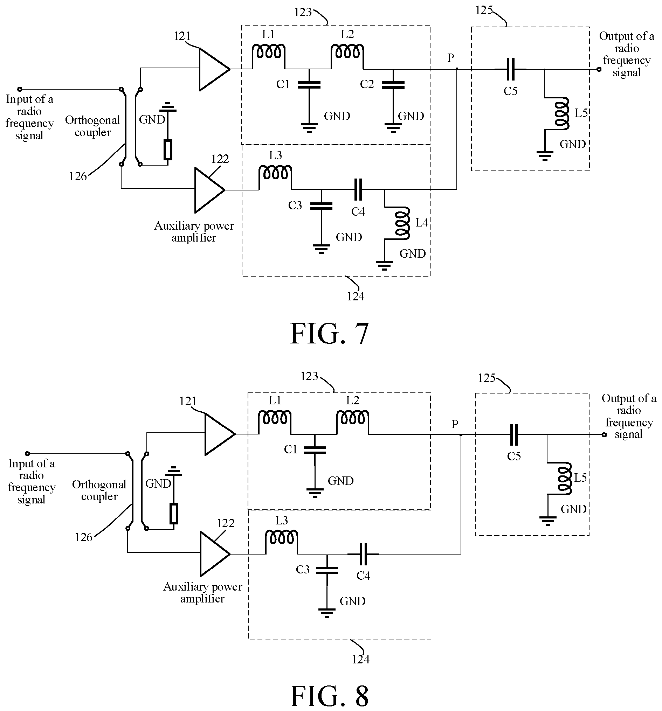

FIG. 7 shows another deformation example of the load modulation power amplifier shown in FIG. 4. In this deformation example, specific changes are that a structure of the auxiliary radio frequency signal matching network 124 changes from the CLLC two-stage network structure in FIG. 4 to an LCCL two-stage network structure in FIG. 7, and a structure of the output combination radio frequency signal matching network 125 changes from the LC single-stage network structure in FIG. 4 to a CL single-stage network structure in FIG. 7. The auxiliary radio frequency signal matching network 124 and the output combination radio frequency signal matching network 125 both include a lumped element.

Specifically, the auxiliary radio frequency signal matching network 124 includes a third inductor L3, a fourth inductor L4, a third capacitor C3, and a fourth capacitor C4. One end of the third inductor L3 is connected to an output end of the auxiliary power amplifier 122. The other end of the third inductor L3 is connected to the third capacitor C3 and the fourth capacitor C4. The other end of the third capacitor C3 is connected to a ground end GND. The other end of the fourth capacitor C4 is connected to the fourth inductor L4 and a fifth capacitor C5 of the output combination radio frequency signal matching network 125. The other end of the fourth inductor L4 is connected to a ground end GND.

In addition, the output combination radio frequency signal matching network 125 includes a fifth inductor L5 and the fifth capacitor C5. The other end of the fifth capacitor C5 is connected to the fifth inductor L5 and a radio frequency signal output end, and the other end of the fifth inductor L5 is connected to a ground end GND.

FIG. 8 shows still another deformation example of the load modulation power amplifier shown in FIG. 4. In the deformation example, resonant frequencies and operating frequencies of a capacitor C2 and an inductor L4 may be designed to be close or equal to each other, to simplify and cancel the two components. In addition, in another deformation example, an output combination radio frequency signal matching network 125 may alternatively be extended to be a matching network including a series inductor L5, a parallel capacitor C5, a series capacitor C6, and a parallel inductor L6, to further extend a matching bandwidth.

It should be noted that embodiments or deformation examples of the present invention are all described in a related manner. For same or similar parts in embodiments or deformation examples, refer to the embodiments or deformation examples. Descriptions of embodiments or deformation examples focus on differences from other embodiments, but are all implemented based on a working principle of the load modulation power amplifier. Details are not described herein again.

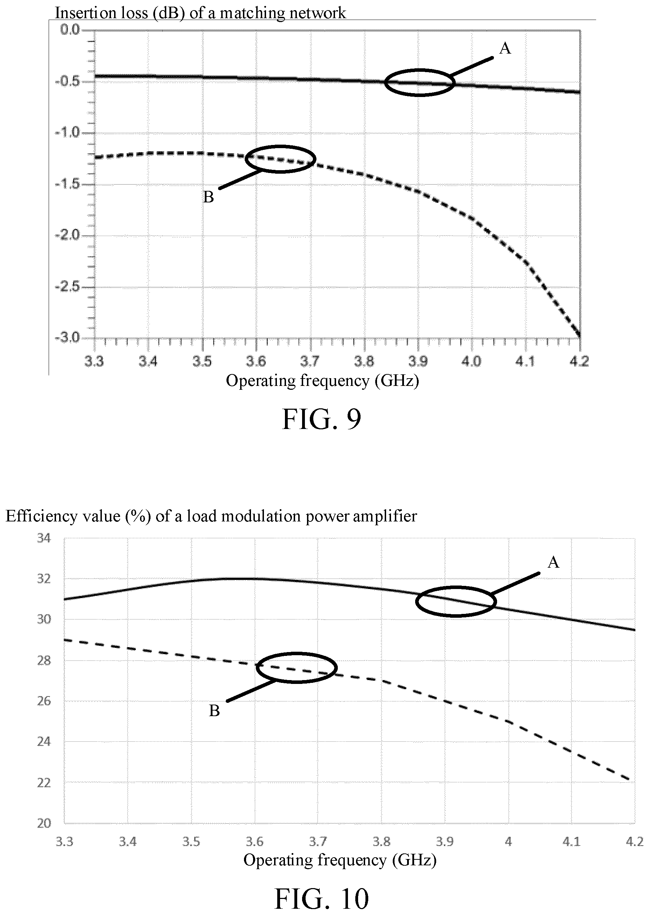

To show a practical technical effect of the load modulation power amplifier provided in embodiments of the present invention, a practical emulation test is performed on the load modulation power amplifier in an n77 frequency band range by the inventor. FIG. 9 shows comparison between an insertion loss of a load modulation power amplifier provided in the present invention and an insertion loss of a load modulation power amplifier in conventional technologies. A curve A is an emulation test result of the load modulation power amplifier provided in the present invention, and a curve B is an emulation test result of the load modulation power amplifier in the conventional technologies. It can be learned from FIG. 9, an insertion loss value of the curve A is significantly less than an insertion loss value of the curve B, and the curve A shows a better wideband characteristic than the curve B.

FIG. 10 shows comparison between an efficiency value of a load modulation power amplifier provided in the present invention and an efficiency value of a load modulation power amplifier in conventional technologies. A curve A is an emulation test result of the load modulation power amplifier provided in the present invention, and a curve B is an emulation test result of the load modulation power amplifier in the conventional technologies. It can be learned from FIG. 10, an efficiency value of the curve A is significantly greater than an efficiency value of the curve B, and the curve A shows a better wideband characteristic than the curve B.

The load modulation power amplifier provided in the present invention may be used in various radio frequency front-end modules. The radio frequency front-end modules may include existing conventional components such as a radio frequency front-end receiving link and a radio frequency front-end transmitting link. Details are not described herein again.

In addition, the load modulation power amplifier provided in the present invention may be further used in an electronic device as an important part of a communication assembly. The electronic device mentioned here refers to a computer device that may be used in a mobile environment and support a variety of communication standards such as GSM, EDGE, TD-SCDMA, TDD-LTE, FDD-LTE, and 5G, and includes a mobile phone, a notebook computer, a tablet computer, a vehicle-mounted computer, and the like. In addition, the technical solutions provided in the present invention are also applicable to application scenarios of another radio frequency front-end module, such as a communication base station.

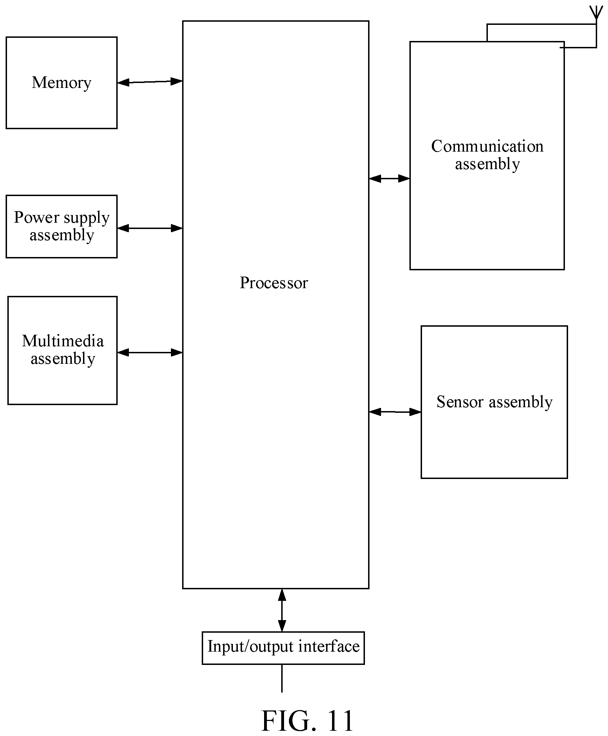

As shown in FIG. 11, the electronic device includes at least a processor and a memory, and may further include a communication assembly, a sensor assembly, a power supply assembly, a multimedia assembly, and an input/output interface based on actual requirements. The memory, the communication assembly, the sensor assembly, the power supply assembly, the multimedia assembly, and the input/output interface each are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field-programmable gate array (FPGA), an application specific integrated circuit (ASIC), a digital signal processing (DSP) chip, or the like. Another sensor assembly, power supply assembly, multimedia assembly, and the like may be implemented by existing conventional components. Details are not described herein again.

Compared with conventional technologies, an operating bandwidth of the load modulation power amplifier provided in the present invention is a plurality of times greater than that in the conventional technologies, and operating efficiency at power back-off of the load modulation power amplifier is effectively improved. In addition, an insertion loss of the load modulation power amplifier provided in the present invention is obviously less than that of a similar product in the conventional technologies. Therefore, the load modulation power amplifier provided in the present invention better meets feature requirements provided in the 5th generation (5G) mobile communication technology, such as a high-bandwidth, high efficiency, and a low loss.

The high-bandwidth load modulation power amplifier and the corresponding radio frequency front-end module provided in the present invention are described above in detail. For a person of ordinary skill in the art, any obvious modification without departing from the substance of the present invention shall fall within the protection scope of the patent right of the present invention.

**Claims**

1. A high-bandwidth load modulation power amplifier, comprising a main power amplifier and an auxiliary power amplifier, and further comprising an orthogonal coupler, a main radio frequency signal matching network, an auxiliary radio frequency signal matching network, and an output combination radio frequency signal matching network, wherein

   an input end of the orthogonal coupler is connected to a radio frequency signal input end, an output end with a phase of +45 degrees of the orthogonal coupler is connected to an input end of the main power amplifier, an output end of the main power amplifier is connected to the main radio frequency signal matching network, an output end with a phase of -45 degrees of the orthogonal coupler is connected to an input end of the auxiliary power amplifier, and an output end of the auxiliary power amplifier is connected to the auxiliary radio frequency signal matching network; and
   the other end of the auxiliary radio frequency signal matching network and the other end of the main radio frequency signal matching network are connected in parallel, and then are connected to the output combination radio frequency signal matching network, and the other end of the output combination radio frequency signal matching network is connected to a radio frequency signal output end.

2. The load modulation power amplifier according to claim 1, wherein
the main radio frequency signal matching network, the auxiliary radio frequency signal matching network, and the output combination radio frequency signal matching network each comprise a lumped element.

3. The load modulation power amplifier according to claim 2, wherein
the main radio frequency signal matching network comprises a first inductor, a second inductor, a first capacitor, and a second capacitor, one end of the first inductor is connected to the output end of the main power amplifier, the other end of the first inductor is connected to the second inductor and the first capacitor, the other end of the first capacitor is connected to a ground end, the other end of the second inductor is connected to the second capacitor and a fifth inductor of the output combination radio frequency signal matching network, and the other end of the second capacitor is connected to a ground end.

4. The load modulation power amplifier according to claim 2, wherein
the auxiliary radio frequency signal matching network comprises a third inductor, a fourth inductor, a third capacitor, and a fourth capacitor, one end of the third capacitor is connected to the output end of the auxiliary power amplifier, the other end of the third capacitor is connected to the third inductor and the fourth inductor, the other end of the third inductor is connected to a ground end, the other end of the fourth inductor is connected to the fourth capacitor and a fifth inductor of the output combination radio frequency signal matching network, and the other end of the fourth capacitor is connected to a ground end.

5. The load modulation power amplifier according to claim 2, wherein
the output combination radio frequency signal matching network comprises a fifth inductor and a fifth capacitor, one end of the fifth inductor is connected to the fifth capacitor and the radio frequency signal output end, and the other end of the fifth capacitor is connected to a ground end.

6. The load modulation power amplifier according to claim 3 or 4, wherein
the second capacitor in the main radio frequency signal matching network and the fourth capacitor in the auxiliary radio frequency signal matching network are combined into one capacitor.

7. The load modulation power amplifier according to claim 3 or 4, wherein
the second capacitor in the main radio frequency signal matching network and the fourth inductor in the auxiliary radio frequency signal matching network are simplified and canceled when resonant frequencies and operating frequencies of the second capacitor and the fourth inductor are equal.

8. The load modulation power amplifier according to claim 2, wherein

   the auxiliary radio frequency signal matching network comprises a third inductor, a fourth inductor, a third capacitor, and a fourth capacitor, one end of the third inductor is connected to the output end of the auxiliary power amplifier, the other end of the third inductor is connected to the third capacitor and the fourth capacitor, the other end of the third capacitor is connected to a ground end, the other end of the fourth capacitor is connected to the fourth inductor and a fifth capacitor of the output combination radio frequency signal matching network, and the other end of the fourth inductor is connected to a ground end; and

the output combination radio frequency signal matching network comprises a fifth inductor and the fifth capacitor, the other end of the fifth capacitor is connected to the fifth inductor and the radio frequency signal output end, and the other end of the fifth inductor is connected to a ground end.

9. A radio frequency front-end module, wherein the radio frequency front-end module comprises the load modulation power amplifier according to any one of claims 1 to 8.

10. An electronic device, comprising the load modulation power amplifier according to any one of claims 1 to 8.

121

124

Main power
amplifier

T2

Input of a radio
frequency
signal

125

P

Output
matching
network

Output of a
radio
frequency
signal

$R_L$

123

122

T1

GND

Auxiliary power
amplifier

FIG. 1

$I_o$

$Z_0, \lambda/4$

$+$

$I_m$

$V_m$

$R$

$V_p$

$-jI_p$

$+$

$-$

$-$

$Z_m$

$Z_p$

FIG. 2

123

125

121

L1

P

C4

L4

Output of a
radio
frequency
signal

C1

C2

Input of a
radio
frequency
signal

Orthogonal
coupler

GND

Main power
amplifier

GND

GND

L3

GND

126

122

L2

C3

C5

Auxiliary power
amplifier

GND

124

## FIG. 3

123

125

121

L1

L2

P

L5

Output of a
radio
frequency
signal

C1

C2

Input of a
radio
frequency
signal

Orthogonal
coupler

GND

Main power
amplifier

GND

GND

126

122

L4

C5

Auxiliary
power
amplifier

C3

C4

GND

L3

GND

GND

124

## FIG. 4

FIG. 5

FIG. 6

**FIG. 7**

**FIG. 8**

Insertion loss (dB) of a matching network

FIG. 9

Efficiency value (%) of a load modulation power amplifier

FIG. 10

Memory

Power supply
assembly

Multimedia
assembly

Processor

Communication
assembly

Sensor assembly

Input/output interface

FIG. 11

| INTERNATIONAL SEARCH REPORT | International application No. |
|---|---|
| | **PCT/CN2023/072799** |

**A.    CLASSIFICATION OF SUBJECT MATTER**

H03F1/42(2006.01)i

According to International Patent Classification (IPC) or to both national classification and IPC

**B.    FIELDS SEARCHED**

Minimum documentation searched (classification system followed by classification symbols)

IPC:H03F

Documentation searched other than minimum documentation to the extent that such documents are included in the fields searched

Electronic data base consulted during the international search (name of data base and, where practicable, search terms used)

CNABS; CNTXT; USTXT; WOTXT; EPTXT; DWPI; VEN; CNKI; IEEE: 放大器, 匹配网络, 射频, 耦合, 输入, 输出, 相位, 45度, amplifier, matching network, radio frequency, couple, input, output, phase, 45 degree

**C.    DOCUMENTS CONSIDERED TO BE RELEVANT**

| Category* | Citation of document, with indication, where appropriate, of the relevant passages | Relevant to claim No. |
|---|---|---|
| PX | CN 114070210 A (VANCHIP (TIANJIN) TECHNOLOGY CO., LTD.) 18 February 2022 (2022-02-18)<br>    description, paragraphs 2-51, and figures 1-11 | 1-10 |
| X | CN 104218897 A (NOKIA CORP.) 17 December 2014 (2014-12-17)<br>    description, paragraphs 25-60, and figures 2-15 | 1-10 |
| X | US 7656964 B1 (RF MICRO DEVICES, INC.) 02 February 2010 (2010-02-02)<br>    description, column 3, line 41 to column 13, line 16, and figures 1-5 | 1-10 |
| A | CN 208063142 U (SHENZHEN DXY TECHNOLOGY CO., LTD.) 06 November 2018 (2018-11-06)<br>    entire document | 1-10 |
| A | US 2012126891 A1 (POSTECH ACADEMY-INDUSTRY FOUNDATION) 24 May 2012 (2012-05-24)<br>    entire document | 1-10 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **10 April 2023** | **27 April 2023** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
Information on patent family members

International application No.

**PCT/CN2023/072799**

| Patent document cited in search report | | | Publication date (day/month/year) | Patent family member(s) | | | Publication date (day/month/year) |
|---|---|---|---|---|---|---|---|
| CN | 114070210 | A | 18 February 2022 | CN | 114070210 | B | 20 September 2022 |
| CN | 104218897 | A | 17 December 2014 | | None | | |
| US | 7656964 | B1 | 02 February 2010 | | None | | |
| CN | 208063142 | U | 06 November 2018 | | None | | |
| US | 2012126891 | A1 | 24 May 2012 | US | 8368465 | B2 | 05 February 2013 |
| | | | | KR | 101128486 | B1 | 27 March 2012 |

Form PCT/ISA/210 (patent family annex) (July 2022)